# FASCICULE DE BREVET EUROPEEN

(11) **EP 1 034 325 B1**
(45) Date de publication et mention de la délivrance du brevet: **31.08.2005**
(21) Numéro de dépôt: 98950142.4
(22) Date de dépôt: 15.10.1998
(51) Int. Cl.: C30B 25/02, H01L 33/00, C30B 29/40

(54) **COUCHE EPITAXIALE DE NITRURE DE GALLIUM**
EPITAKTISCHE GALLIUMNITRIDSCHICHT
GALLIUM NITRIDE EPITAXIAL LAYER

(30) Priorité: 20.10.1997 FR 9713096
(43) Date de publication de la demande: 13.09.2000
(60) Demande divisionnaire: 03005910.9
(73) Titulaire: Lumilog, 06220 Vallauris (FR)
(72) Inventeur: BEAUMONT, Bernard, F-06560 Valbonne (FR); GIBART, Pierre, F-06740 Châteauneuf de Grasse (FR); GUILLAUME, Jean-Claude, F-06650 La Gaude (FR); NATAF, Gilles, chemin de la Gabelle F-06220 Golfe Juan (FR); VAILLE, Michel, F-06600 Antibes (FR); HAFFOUZ, Soufien, Sidi Bouzid Tunisia (TN)
(74) Mandataire: Ahner, Francis
(86) Numéro de dépôt international: PCT/FR1998/002212
(87) Numéro de publication internationale: WO 1999/020816

(56) Documents cités:
- EP-A- 0 284 437
- EP-A- 0 506 146
- EP-A- 0 711 853
- WO-A-96/42114
- KAPOLNEK D ET AL: "ANISOTROPIC EPITAXIAL LATERAL GROWTH IN GAN SELECTIVE AREA EPITAXY" APPLIED PHYSICS LETTERS, vol. 71, no. 9, 1 septembre 1997, pages 1204-1206, XP000720234
- NAM O -H ET AL: "LATERAL EPITAXY OF LOW DEFECT DENSITY GAN LAYERS VIA ORGANOMETALLICVAPOR PHASE EPITAXY" APPLIED PHYSICS LETTERS, vol. 71, no. 18, 3 novembre 1997, pages 2638-2640, XP000726169
- KAPOLNEK ET AL: "Selective area epitaxy of GaN for electron field emission devices" JOURNAL OF CRYSTAL GROWTH., vol. 170, no. 1-4, janvier 1997, pages 340-343, XP004087130 AMSTERDAM NL cité dans la demande
- KATO ET AL.: "Selective growth of wurtzite GaN and AlxGa1-xN on GaN/sapphire substrates by metalorganic vapour phase epitaxy" JOURNAL OF CRYSTAL GROWTH., vol. 144, 1994, pages 133-140, XP000483655 AMSTERDAM NL cité dans la demande
- MOLNAR ET AL.: "Growth of gallium nitride by hydride vapour phase epitaxy" JOURNAL OF CRYSTAL GROWTH., vol. 178, no. 1-2, juin 1997, pages 147-156, XP004084981 AMSTERDAM NL

## Description

La présente invention concerne un procédé de réalisation d'une couche épitaxiale de nitrure de gallium (GaN) ainsi que les couches épitaxiales de nitrure de gallium (GaN) susceptibles d'être obtenues par ledit procédé. Un tel procédé permet d'obtenir des couches de nitrure de gallium d'excellente qualité.

Elle concerne également les dispositifs optiques à courte longueur d'onde ou les dispositifs électroniques à haute puissance et haute fréquence munis d'une telle couche épitaxiale de nitrure de gallium.

Elle concerne notamment les composants optoélectroniques élaborés sur de telles couches de nitrure de gallium.

On connaît des procédés pour obtenir des couches relativement épaisses de GaN, par exemple de 100 à 200 micromètres. La méthode couramment utilisée est l'épitaxie en phase vapeur à partir de chlorures et d'hydrures (HVPE). On utilise soit des substrats de saphir, soit des couches de GaN sur saphir de 200 micromètres d'épaisseur fabriquées par épitaxie en Phase Vapeur par Pyrolyse d'Organométalliques (EPVOM). Toutefois, le désaccord de paramètre de maille cristalline entre le saphir et le GaN est tel que l'accumulation de contraintes dans les couches conduit à des fissures et empêche d'enlever le substrat de saphir. Toutes les innovations expérimentales (traitement de la surface du saphir en début de croissance par GaCl, dépôt d'une couche intermédiaire ZnO), n'ont pas permis de résoudre ce problème. Actuellement les couches de GaN relativement épaisses présentent une largeur de raie de double diffraction X (DDX) de l'ordre d'au mieux 300 arcsec, ce qui signifie que la qualité cristallographique n'excède pas celle des couches élaborées en EPVOM ou en Epitaxie par Jets Moléculaires (EJM).

En d'autres termes, aucun substrat potentiel, saphir, ZnO, 6H-SiC, LiAlO₂, n'est idéal pour l'épitaxie des nitrures (désaccord de maille et coefficient de dilatation thermique trop élevé, instabilité thermique).

On connaît par ailleurs depuis longtemps l'effet laser (par pompage optique) sur GaN. Bien que des diodes laser à base de nitrure III-V aient été réalisées, la qualité cristalline des couches de nitrures qui constituent la structure de ces lasers est très moyenne. On a mesuré des densités de dislocation allant de 10⁹ à 10¹⁰ cm⁻².

En fait, les défauts liés à l'obtention de couches épitaxiales de GaN relativement épaisses indiquées ci-dessus ont considérablement ralenti le développement des diodes laser pourvues de telles couches : résiduel n élevé, absence de monocristaux et de substrats appropriés, impossibilité de réaliser le dopage p. Journal of crystal growth 170 (1997) 147-156 décrit la production des cristaux de GaN par HVPE.

La publication D. Kalponek et al, Journal of Crystal Growth, 170 (1997) 340-343 mentionne la croissance localisée de nitrure dans des ouvertures formées dans un masque de manière à former des structures pyramidales. Ce document néanmoins ne décrit ni ne suggère la formation par coalescence des motifs ou îlots de couches lisses de nitrure de gallium.

La publication Y. Kato, S. Kitamura, K. Hiramatsu, N. Sawaki, J. Cryst. Growth, 144, 133 (1994) décrit la croissance sélective de nitrure de gallium par EPVOM sur des substrats de saphir sur lesquels a été déposée une couche mince de nitrure de gallium masquée par une couche de SiO₂ gravée pour dégager des bandes continues de nitrure de gallium.

Cependant, l'épitaxie localisée ainsi réalisée ne met en oeuvre ni la croissance latérale ni l'anisotropie de croissance telle qu'elle sera décrite ci-après.

Le document EP 0 506 146 décrit un procédé de croissance locale et latérale mettant en jeu un masque, mis en forme par lithographie, pour localiser la croissance. Les exemples de couches lisses ne concernent en aucun cas le nitrure de gallium. Ces exemples mentionnent l'homoépitaxie GaAs sur un substrat GaAs, InP sur substrat InP. WO-A-9 642 111 décrit la croissance des cristaux semi-conducteurs sur des substrates de wurtzite.

Le procédé selon l'invention a pour objet d'obtenir des couches cristallines permettant la réalisation de dispositifs optoélectroniques (diodes laser notamment) présentant des performances et des durées de vie supérieures à celles obtenues précédemment.

Les inventeurs ont trouvé que le traitement d'un substrat par un dépôt d'un diélectrique approprié, suivi d'un dépôt de nitrure de gallium, suivi lui-même d'un recuit thermique, induit la formation d'îlots de nitrure de gallium quasi sans défauts.

La coalescence de tels îlots engendrés par le traitement thermique conduit à une couche de nitrure de gallium d'excellente qualité.

L'invention concerne un procédé de réalisation d'une couche de nitrure de gallium (GaN), la couche et son utilisation tel que defini dans les revendications indépendentes. Des caractéristiques optionelles de l'objet revendiqué sont contenues dans les revendications dependentes.

Le substrat présente une épaisseur de quelques centaines de micromètres généralement (environ 200 micromètres notamment) et peut être choisi dans le groupe constitué par le saphir, ZnO, 6H-SiC, LiAlO₂, LiGaO₂, MgAl₂O₄. Le substrat est de préférence traité préalablement par nitruration.

Le diélectrique est de préférence du type Si_{X}N_{Y}, notamment Si₃N₄. On cite également le SiO₂ mais d'autres diélectriques bien connus pourraient être utilisés. On réalise le dépôt du diélectrique dans la chambre de croissance du nitrure de gallium à partir de silane et d'ammoniac.

De préférence, le gaz vecteur est un mélange N₂, H₂.

La couche de diélectrique est une monocouche atomique, où une couverture de l'ordre du plan atomique.

Le substrat est ensuite repris par épitaxie en EPVOM. Il se développe des motifs ou îlots réguliers. L'examen en microscopie électronique en haute résolution montre que la densité de dislocations de GaN dans les motifs ou îlots réguliers, qui a donc cru sans contraintes d'hétéroépitaxie, est très inférieure à celle qui se produit par le dépôt direct de nitrure de gallium sur le substrat. Ainsi, la croissance de GaN, qui s'effectue latéralement selon les directions [10-10], sur une surface de diélectrique donc sans être en relation épitaxiale avec le substrat de saphir, conduit à une bien meilleure qualité cristalline de GaN que les procédés habituels. Après obtention desdits motifs, la croissance peut être poursuivie, soit en EPVOM soit en HVPE. Elle s'effectue latéralement, jusqu'à coalescence des îlots. Ces surfaces résultant de la coalescence d'îlots présentent une qualité cristalline supérieure aux couches hétéroépitaxiées sur saphir.

Le dépôt de nitrure de gallium s'effectue généralement en deux étapes. Une première étape à une température d'environ 600°C pour le dépôt d'une couche tampon, de laquelle seront issus les motifs GaN puis à température plus élevée (environ 1000-1100°C) pour la croissance d'une épicouche à partir desdits motifs.

L'invention concerne un procédé caractérisé en ce que l'on grave la couche de diélectrique de façon à définir des ouvertures et à exposer les zones du substrat en regard et l'on reprend le substrat masqué et gravé dans des conditions de dépôt, par épitaxie, de nitrure de gallium de façon à induire le dépôt de motifs de nitrure de gallium sur les zones en regard et la croissance anisotrope et latérale desdits motifs, la croissance latérale étant poursuivie jusqu'à la coalescence des différents motifs.

L'invention concerne un procédé de réalisation d'une couche épitaxiale de nitrure de gallium (GaN), comprenant le dépôt sur un substrat d'une couche mince de nitrure de gallium caractérisé en ce que :
- l'on dépose sur ladite couche mince de nitrure de gallium une couche de diélectrique,
- on grave la couche de diélectrique de façon à définir des ouvertures et à exposer les zones de ladite couche mince de nitrure de gallium qui sont en regard,
- on reprend le substrat épitaxié, masqué et gravé dans des conditions de dépôt, par épitaxie, de nitrure de gallium de façon à induire le dépôt de motifs nitrure de gallium sur les zones en regard et la croissance anisotrope et latérale desdits motifs, la croissance latérale étant poursuivie jusqu'à la coalescençe des différents motifs.

Le procédé selon l'invention est remarquable en ce qu'il limite la densité de défauts générés par le désaccord de paramètre entre GaN et le substrat par une méthode combinant l'épitaxie localisée, l'anisotropie de croissance et la croissance latérale ce qui permet de limiter les contraintes d'épitaxie.

Le procédé selon l'invention fait appel à des techniques de dépôt et de gravure bien connues de l'homme du métier.

Selon le deuxième mode de réalisation, dans la chambre de croissance on réalise le dépôt d'un diélectrique de quelques nanomètres d'épaisseur. Ensuite, par photolithographie, on définit des ouvertures dans la couche de diélectrique exposant ainsi des zones micrométriques de la surface du substrat.

Le substrat, masqué et gravé, est repris en EPVOM.

Le substrat présente une épaisseur de quelques centaines de micromètres généralement (environ 200 micromètres notamment) et peut être choisi dans le groupe constitué par le saphir, ZnO, 6H-SiC, LiAlO₂, LiGaO₂, MgAl₂O₄.

Le diélectrique est de préférence du type Si_{X}N_{Y}, notamment Si₃N₄. On cite également le SiO₂ mais d'autres diélectriques bien connus pourraient être utilisés. On réalise le dépôt du diélectrique dans la chambre de croissance du nitrure de gallium à partir de silane et d'ammoniac directement sur le substrat tel que décrit ci-dessus.

Selon le troisième mode de réalisation, le nitrure de gallium est d'abord épitaxié en EPVOM sur le substrat. Puis dans la chambre de croissance on réalise le dépôt d'un diélectrique de quelques nanomètres d'épaisseur. Ensuite, par photolithographie, on définit des ouvertures dans la couche de diélectrique exposant ainsi des zones micrométriques de la surface de nitrure de gallium.

Le substrat épitaxié, masqué et gravé est repris en EPVOM.

Le substrat présente une épaisseur de quelques centaines de micromètres généralement (environ 200 micromètres notamment) et peut être choisi dans le groupe constitué par le saphir, ZnO, 6H-SiC, LiAlO₂, LiGaO₂, MgAl₂O₄.

Le diélectrique est de préférence du type Si_{X}N_{Y}, notamment Si₃N₄. On cite également le SiO₂ mais d'autres diélectriques bien connus pourraient être utilisés. On réalise le dépôt du diélectrique dans la chambre de croissance du nitrure de gallium à partir de silane et d'ammoniac immédiatement après le dépôt de nitrure de gallium.

La gravure du diélectrique est notamment réalisée par photolithographie.

On définit des ouvertures ponctuelles ou sous forme de bandes dans la couche de nitrure de silicium exposant ainsi sur un motif micrométrique la surface de nitrure de gallium. Les ouvertures sont de préférence des polygones réguliers, notamment de forme hexagonale. Avantageusement, les ouvertures ponctuelles sont inscrites dans un cercle de rayon inférieur à 10 micromètres, tandis que les ouvertures en forme de bandes ont une largeur inférieure à 10 micromètres, la longueur des bandes n'étant limitée que par la dimension du substrat.

L'espacement des ouvertures est régulier et doit permettre l'épitaxie localisée de nitrure de gallium puis la croissance anisotrope et latérale.

En général, la proportion de surface de substrat ou de nitrure de gallium dégagée par rapport à la surface totale du substrat est comprise entre 5 et 80 %, de préférence entre 5 et 50%.

On a trouvé que les atomes de gallium ne se déposaient pas sur le diélectrique et, en d'autres termes, que cette surface gravée de diélectrique permettait la concentration des atomes de gallium sur les ouvertures.

Le substrat est ensuite repris par épitaxie en EPVOM. Il se développe des motifs ou îlots réguliers. L'examen en microscopie électronique en haute résolution montre que la densité de dislocations de GaN dans les motifs ou îlots réguliers, qui a donc crû sans contraintes d'hétéroépitaxie, est très inférieure, dans le cas de la troisième variante, à celle existant dans la première couche de GaN. Ainsi, la croissance de GaN, qui s'effectue latéralement selon les directions [10-10], sur une surface de diélectrique donc sans être en relation épitaxiale avec le substrat de saphir, conduit à une bien meilleure qualité cristalline de GaN que les procédés habituels. Après obtention d'un réseau de motifs réguliers, la croissance peut être poursuivie, soit en EPVOM soit en HVPE. Elle s'effectue latéralement, jusqu'à coalescence des îlots. Ces surfaces résultant de la coalescence d'îlots présentent une qualité cristalline supérieure aux couches hétéroépitaxiées sur saphir.

L'originalité du procédé consiste donc à utiliser l'anisotropie de croissance pour induire une croissance latérale allant jusqu'à la coalescence et obtenir ainsi une couche continue de GaN, sans contraintes. La croissance latérale s'effectue à partir de motifs ou îlots de nitrure de gallium présentant des densités de défauts réduites, lesdits motifs étant obtenus par épitaxie localisée.

Selon une variante, la reprise en épitaxie est effectuée par du nitrure de gallium non dopé.

Selon une autre variante, la reprise en épitaxie est effectuée par du nitrure de gallium dopé avec un dopant choisi dans le groupe constitué par le magnésium, le zinc, le cadmium, le béryllium, le calcium, le carbone, notamment avec du magnésium. On a trouvé en effet que le dopage du nitrure de gallium par un agent dopant, notamment le magnésium, modifiait le mode de croissance de GaN et conduisait à une augmentation relative de la vitesse de croissance selon les directions <10-11> par rapport à la vitesse de croissance selon la direction [0001]. De préférence, le rapport dopant/Ga en mole est supérieur à 0 et inférieur ou égal à 1, avantageusement inférieur à 0,2.

Selon une autre variante avantageuse, la reprise en épitaxie est effectuée en deux temps.

En premier lieu, le dépôt sur le diélectrique gravé ou d'épaisseur de l'ordre de l'angström, est effectué par du nitrure de gallium non dopé dans des conditions d'anisotropie de croissance verticale puis on poursuit le dépôt de nitrure de gallium en présence d'un dopant pour favoriser la croissance latérale conduisant à la coalescence des motifs.

L'invention est également relative aux couches épitaxiales de nitrure de gallium, caractérisées en ce qu'elles sont susceptibles d'être obtenues par le procédé ci-dessus. Avantageusement ces couches présentent une densité de défauts inférieure à celles obtenues dans l'art antérieur, notamment inférieur à environ 10⁹.cm⁻².

De préférence, la couche épitaxiale présente une épaisseur comprise entre 1 et 1000 micromètres et éventuellement en ce qu'elle est auto-supportée après séparation du substrat.

L'invention trouve une application particulièrement intéressante dans la réalisation de diodes laser munies d'une couche épitaxiale de nitrure de gallium décrite précédemment.

On va décrire maintenant plusieurs modes de réalisations du procédé selon l'invention en relation avec les figures 1 à 8 et les exemples.
- La figure 1 est une vue schématique en coupe transversale d'une couche de nitrure de gallium selon l'invention.
- La figure 2 est une photographie montrant des motifs pyramidaux réguliers formés lors de l'épitaxie localisée par du nitrure de gallium non dopé, lorsque les ouvertures dans le diélectrique sont ponctuelles.
- La figure 3 est une vue en coupe perpendiculaire à la direction [11-20] d'une pyramide hexagonale tronquée, localisée de nitrure de gallium.
- La figure 4 montre la variation des valeurs en µm W_{T}, W_{B} et H, en fonction du temps de croissance en mn. W_{T}, W_{B} et H sont définis sur la Figure 3.
- La figure 5 montre la variation des vitesses de croissance normalisées au flux molaire de TMGA dans les directions [0001] et <10-11> en fonction du rapport molaire Mg/Ga en phase vapeur.
- La figure 6 est une photographie des pyramides observées obtenues par reprise en épitaxie localisée avec GaN dopé par le magnésium. La figure 6 montre l'effet avantageux du dopant Magnésium sur le mode de croissance de GaN en ce qu'il permet d'obtenir beaucoup plus rapidement la coalescence des motifs aboutissant à la formation d'une couche continue de nitrure de gallium sans contrainte de relation d'épitaxie.
- La figure 7 est une photographie des pyramides obtenues en cours de croissance selon l'exemple 5 en microscopie électronique en transmission.
- La figure 8 est une photographie des pyramides obtenues en cours de croissance selon l'exemple 5 en microscopie électronique à balayage.

### Exemple 1 : Dépôt d'une couche de nitrure de gallium non dopé

On utilise un réacteur vertical approprié opérant à pression atmosphérique pour l'épitaxie en Phase Vapeur par Pyrolyse d'Organométalliques. Sur un substrat de saphir (0001) 1 de 200 µm d'épaisseur on dépose par épitaxie une couche mince de nitrure de gallium 2 de 2 µm d'épaisseur, en Phase Vapeur par Pyrolyse d'Organométalliques à 1080°C. La source de gallium est le Triméthylgallium (TMGa) et la source d'azote est l'ammoniac. Une telle méthode est décrite dans de nombreux documents.

Les conditions expérimentales sont les suivantes :

Le véhicule gazeux est un mélange d'H₂ et N₂ en proportions égales (4sl/mn). L'ammoniac est introduit par un conduit séparé (2sl/mn).

Après la croissance de la première épicouche de nitrure de gallium, une fine couche d'un film 3 de nitrure de silicium est déposée en tant que masque pour la croissance sélective ultérieure de nitrure de gallium en utilisant SiH₄ et NH₃ à un débit de 50 sccm et 2 slm, respectivement.

Les observations au microscope à transmission d'électrons sur des coupes tranversales montrent que le masque obtenu forme une couche continue amorphe ayant une épaisseur d'environ 2 nm. Comme la stoechiométrie de ce film n'a pas été mesurée on utilisera pour la suite de cet exposé le terme SiN. Il semble néanmoins que la stoechiométrie corresponde au terme Si₃N₄. Bien qu'extrêmement fine, cette couche de SiN s'est révélée être un masque parfaitement sélectif. La gravure par photolithographie et attaque ionique réactive est alors effectuée pour dégager des ouvertures hexagonales 4 circonscrites par un cercle de 10 µm de diamètre. La distance entre les centres de deux ouvertures voisines dans le masque est de 15 µm. La reprise en épitaxie sur les zones 5 de nitrure de gallium exposées pour déposer le nitrure de gallium est effectuée sur les échantillons gravés dans des conditions similaires à celles utilisées pour la croissance standard de nitrure de gallium à l'exception du débit de TMGa. Celui-ci est fixé à une valeur plus faible (typiquement 16 µMole/mn pour les expériences avec le nitrure de gallium non dopé) afin d'éviter les vitesses de croissance élevées résultant de la collecte très efficace vers les zones 5 des atomes de gallium rencontrant la surface du masque. L'épitaxie localisée révèle une vitesse de croissance de nitrure de gallium 6 dans la direction [0001] Vc pratiquement proportionnelle à l'espacement entre deux ouvertures.

De plus, aucune nucléation n'est observée sur SiN même pour des espacements importants. On en conclut donc que la nucléation et la croissance de GaN s'effectue sélectivement dans les ouvertures 5. Par conséquent les surfaces masquées se comportent comme des concentrateurs dirigeant les atomes vers les ouvertures.

Les vitesses de croissance sont mesurées soit in situ par réflectométrie laser, soit ensuite par mesure en Microscopie Electronique à Balayage (MEB) sur les vues de dessus ou des coupes.

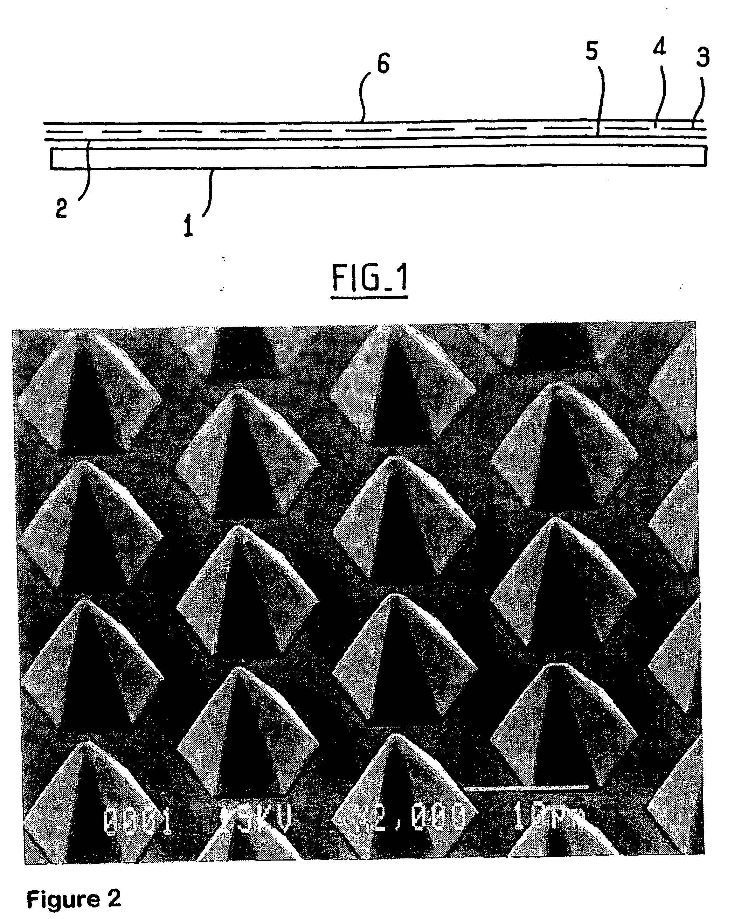

La figure 2 est une photographie au MEB montrant le développement des pyramides.

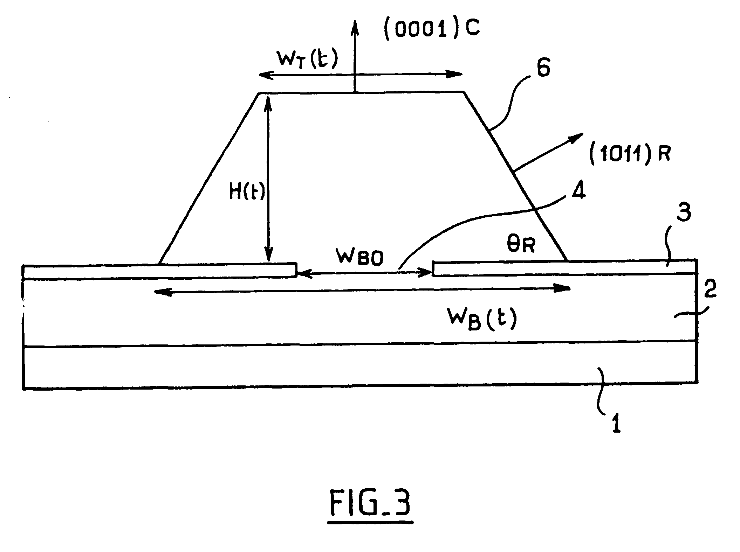

La figure 3 est une vue en coupe perpendiculaire à la direction [11-20] d'une pyramide hexagonale localisée de nitrure de gallium, tronquée. W_{T}, W_{B} et H sont fonction du temps t. θ_{R} est l'angle entre (0001) et (10-11) délimitant les plans. W_{B0} est la largeur des ouvertures dans le masque SiN.

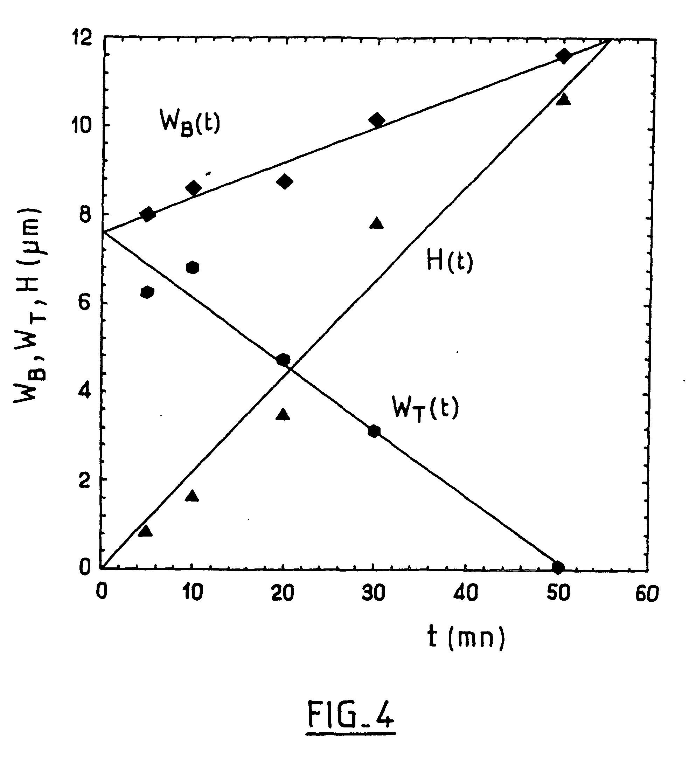

La figure 4 montre la variation des valeurs W_{T}, W_{B} et H en µm en fonction du temps de croissance en mn. A partir des régressions linéaires par les points expérimentaux, on obtient les résultats suivants :
V_{R}= 2,1µm /h (vitesse latérale selon la direction [10-11]),
V_{C}= 13µm /h (vitesse selon la direction [0001]),
W_{B0} = 7,6µm,
θ_{R} = 62,1°.

Lorsque Wₜ = 0 à t₀ (la pyramide présente un sommet de largeur nulle), la hauteur H varie à une vitesse plus faible donnée par la formule V_{R}/cos(θ_{R}).

On notera que V_{C} est extrêmement élevée comparé à la vitesse de 1µm /h mesurée pour une épitaxie standard sur un substrat (0001) utilisant la même composition de la phase vapeur. De ce fait le rapport V_{R}/V_{C} est seulement de 0,15 environ.

### Exemple 2 : Dépôt d'une couche de nitrure de gallium avec adjonction de magnésium dans la phase gazeuse

L'expérience de l'exemple 1 est reproduite à l'exception du fait que l'on introduit 2,8 µ Mole/mn de (MeCp)₂Mg en phase vapeur. Les conditions utilisées sont : temps de croissance 30mn, température de croissance 1080°C, TMGa 16 µMole/mn, N₂, H₂ et NH₃ 2sl/mn pour chacun.

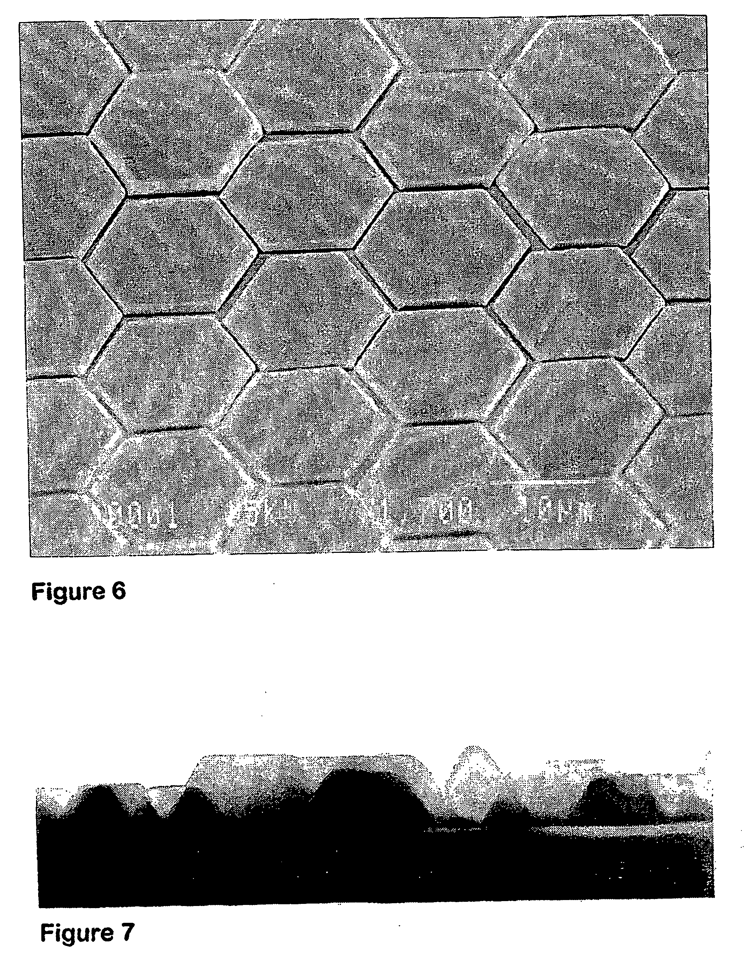

La figure 6 montre que la présence de magnésium accroît le rapport V_{R}/V_{C} bien au delà du seuil cos(θ_{R}) et par conséquent la facette supérieure (0001) s'élargit. La sélectivité de la croissance n'est pas affectée par la présence de (MeCp)2Mg mais l'anisotropie de croissance est avantageusement modifiée.

### Exemple 3 : Influence du rapport molaire Me/Ga

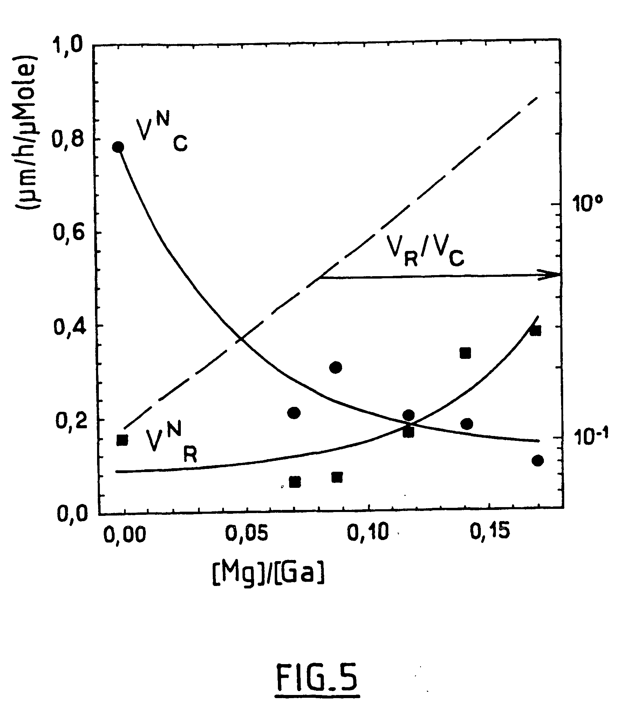

La figure 5 montre la variation des vitesses de croissance normalisées au flux molaire de TMGA dans les directions [0001] et [10-11] en fonction du rapport molaire Mg/Ga en phase vapeur.

En pratique, on a choisi de maintenir un flux constant de (MeCp)₂Mg et de faire varier la quantité de TMGA. Cela permet de s'assurer que la concentration de Mg disponible à la surface des îlots de croissance est identique pour tous les échantillons.

Du fait que la croissance est linéairement contrôlée par la quantité de gallium fournie, on normalise les vitesses de croissances pour les comparer.

V^{N}_{C} décroît rapidement de 0,8 à 0,1µm/h/µMole, tandis que V^{N}_{R} augmente de 0,16 à 0,4 µm/h/µMole quand le rapport molaire Mg/Ga varie de 0 à 0,17. La ligne en pointillé est la courbe du rapport V_{R}/V_{C} obtenue par extrapolation. L'ordonnée de droite est V_{R}/V_{C}.

Cette courbe montre que l'incorporation de Mg permet un contrôle aisé de la structure pyramidale en modifiant l'anisotropie de croissance. Cela suggère que Mg agisse comme un surfactant favorisant l'adsorption de gallium sur les faces {10 11} mais à l'inverse l'empêchant sur les faces (0001).

### Exemple 4 : Dépôt d'une couche de nitrure de gallium en deux temps

Dans le premier temps, le procédé selon l'invention est mis en oeuvre par reprise en épitaxie dans des conditions opératoires comparables à celles de l'exemple 1.

Un masque de SiN est déposé sur une couche de GaN préalablement déposée' de façon épitaxique dans un réacteur approprié sur un substrat de cristallisation tel que la saphir. Des ouvertures linéaires de largeur 5 µm espacées de 5 µm sont ensuite pratiquées dans le masque pour dégager les zones de la couche sous-jacente. Les ouvertures linéaires sont avantageusement orientées dans la direction [10-10] de GaN bien que la variante du procédé décrite dans cet exemple puisse être conduite à terme pour d'autres orientations des ouvertures linéaires notamment selon [11-20] de GaN.

La reprise par épitaxie sur les zones dégagées est effectuée par du GaN non intentionnellement dopé dans des conditions opératoires telles que la vitesse de croissance selon la direction [0001] des motifs de GaN excède suffisamment la vitesse de croissance selon la direction normale au flancs inclinés des dits motifs. Dans de telles conditions, l'anisotropie de la croissance conduit à la disparition de la facette (0001). Le premier temps de la mise en oeuvre du procédé s'achève lorsque la disparition de la facette (0001) du motif de GaN est assurée. En fin du premier temps, les motifs de GaN ont pris la forme de bande dont la section est triangulaire. Il est cependant possible de poursuivre le premier temps jusqu'à coalescence des motifs de GaN pour recouvrir complètement le masque. Dans ce cas la section des motifs de GaN coalescés est une ligne en zigzag.

Le deuxième temps consiste en la reprise en épitaxie par du GaN dopé, notamment par du Magnésium selon l'exemple 2 ou 3, sur les motifs de GaN créés dans le premier temps. Sous l'effet de l'introduction du dopant, l'anisotropie de croissance est favorable à la planarisation des motifs de GaN. La facette C réapparaît au sommet de chacun des motifs de GaN obtenus dans le premier temps. Durant ce deuxième temps, les motifs de GaN dopés se développe avec une expansion de la facette C et au contraire une diminution de la surface des flancs Le deuxième temps du procédé selon l'exemple prend fin lorsque les flancs ont disparus, la surface supérieure du dépôt formée par les motifs coalescés de GaN dopé étant alors plane.

La mise en oeuvre du procédé selon l'invention en deux temps comme décrit ci-dessus conduit d'une part à l'obtention de couche de GaN plane, pouvant donc servir de substrat GaN pour le dépôt ultérieur, par reprise d'épitaxie, de structure de dispositifs, notamment de structure de diode laser, mais conduit d'autre part à une amélioration très avantageuse de la qualité cristalline dudit substrat. En effet, les lignes de défauts cristallins de la couche de GaN sous-jacente se propagent, par l'ouverture pratiquée dans le masque, verticalement dans le motif de GaN non dopé créé dans le premier temps. Mais il apparaît que ces lignes de défauts se courbent pendant le deuxième temps consacré au dépôt du motifs de GaN dopé. Il en résulte des lignes de défauts qui se propagent dans des directions parallèles à la surface de la couche de GaN masqué.

Du fait de la modification de la direction de propagation des défauts, la surface supérieure formée par la coalescence des motifs de GaN est quasiment exempt de défauts émergeants dans des domaines compatibles avec la taille des dispositifs électroniques tel que les diodes lasers en GaN.

### Exemple 5 : Dépôt d'une couche de nitrure de gallium directement sur un substrat masqué par un diélectrique

Dans cet exemple, on illustre une méthode permettant d'obtenir la formation spontanée des motifs ou îlots de nitrure de gallium sur un substrat par un traitement consistant à recouvrir le substrat par un film de diélectrique, notamment de nitrure de silicium, dont l'épaisseur est de l'ordre de l'angström. Cette méthode permet avantageusement d'éviter le recours à la gravure ex-situ du masque par des techniques lourdes telles que photolithographie et attaque chimique.

On utilise un réacteur de croissance épitaxiale approprié pour l'épitaxie en phase vapeur par pyrolyse d'organométalliques. Explicitement, un substrat, notamment en saphir (0001) préalablement préparé chimiquement par dégraissage et décapage dans une solution acide H₂SO₄: H₃PO₄, dans un rapport 3:1 est porté à une température d'environ 1050-1080°C pour être nitruré par exposition à un flux de NH₃ pendant environ 10 minutes. Après cette étape de nitruration, on forme sur la surface du substrat un film très mince de nitrure de silicium, le film étant obtenu par réaction à une température de 1080°C entre NH₃ et du silane SiH₄ pendant un temps suffisamment court pour limiter l'épaisseur du film à celle d'un plan atomique.

Les conditions opératoires sont les suivantes :

Le véhicule gazeux est un mélange d'azote et d'hydrogène en proportions égales (4 sl/mn). L'ammoniac est introduit avec un débit de 2 sl/mn tandis que le silane, sous forme diluée à 50 ppm dans de l'hydrogène, est introduit avec un débit de 50 scc/mn. Dans ces conditions, la durée typique de réaction entre NH₃ et SiH₄ est de l'ordre de 30 secondes.

Les étapes successives sont suivies par réflectrométrie laser (LR) et Microscopie Electronique par Transmission (TEM).

Après achèvement de la formation de la couche de diélectrique, une couche de nitrure de gallium continue et d'épaisseur de 20 à 30 nm est déposée sur le film de diélectrique. Le dépôt de la couche de GaN est fait à basse température de l'ordre de 600°C.

Après achèvement du dépôt de la couche de GaN, on procède à un recuit à haute température de l'ordre de 1080°C de la couche de GaN. Sous l'effet conjoint de l'élévation de la température, de la présence dans le véhicule gazeux d'une quantité d'hydrogène suffisante et de la présence du film très mince de diélectrique sous la couche de GaN, la morphologie de ladite couche de GaN subit une profonde modification résultant d'une recristallisation en phase solide par transport de masse. Lorsque la température approche des 1060°C, on note que la réflectivité de la couche tampon diminue soudainement. La couche tampon initialement continue est alors convertie en une couche discontinue formée d'îlots de nitrure de gallium.

En fin de ce processus spontané et *in-situ* de recristallisation, on obtient des motifs ou îlots de GaN de très bonne qualité cristalline et conservant une relation d'épitaxie avec le substrat grâce à la très faible épaisseur de la couche de diélectrique. Les motifs ou îlots de GaN sont isolés les uns des autres par des zones ou la couche de diélectrique est mise à nu. Les hauteurs caractéristiques des îlots sont de l'ordre de 2400 angströms. L'observation obtenue avec un microscope électronique en transmission montre que les îlots tendent à prendre la forme de pyramides tronquées (figure 7).

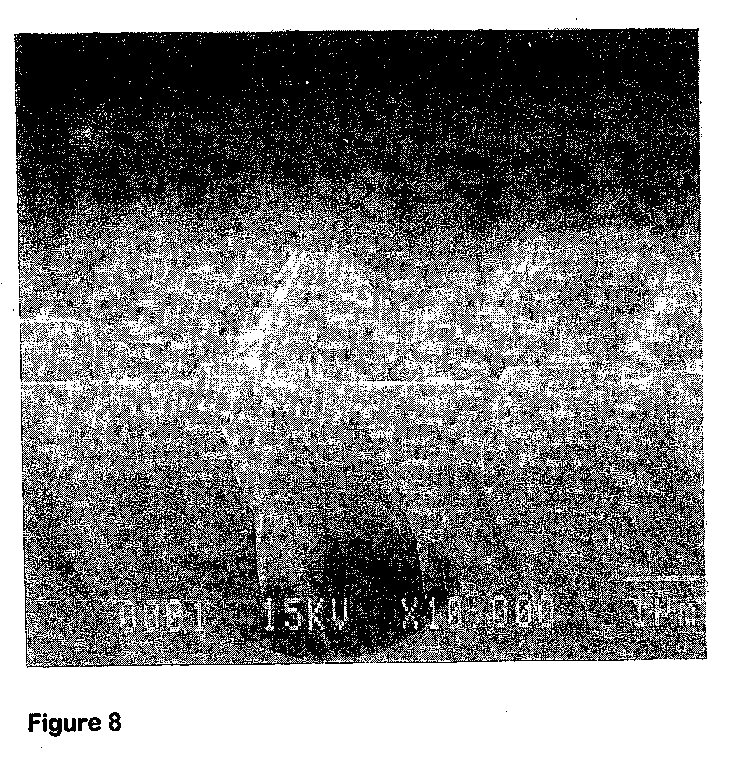

La figure 8 est une image au microscope électronique à balayage d'un échantillon obtenu dans des conditions opératoires modifiées afin d'accroître les dimensions des îlots jusqu'à des valeurs micrométriques comparables à celles des îlots ou motifs obtenus dans les ouvertures d'un masque (cf. exemple 1) réalisées ex-situ par photolithographie.

Lors de la reprise ultérieure en épitaxie par du nitrure de gallium sur la surface d'un échantillon, les zones du diélectrique où la couche du diélectrique est mise à nu fonctionneront comme le masque de la figure 1 et les motifs ou îlots de GaN ainsi spontanément formés sont les analogues des motifs de GaN (cf. figure 1 ou figure 2) localisés dans les ouvertures (cf. figure 1) réalisées ex-situ dans le masque (cf. figure 1). Explicitement, les motifs ou îlots de GaN se développeront par croissance latérale et verticale.

Des couches de GaN ont été ainsi obtenues par coalescence des motifs de GaN présentant une densité de défauts de l'ordre de 10⁸ cm⁻², soit inférieure de deux ordres de grandeur à la densité de défauts présents dans les couches de nitrure de gallium élaborées selon les méthodes conventionnelles.

Ainsi, dans les variantes du procédé décrites dans les exemples précédents, notamment l'exemple 4 décrivant une variante en deux temps, le recours au procédé ex-situ de gravure des ouvertures dans un masque peut être avantageusement évité et remplacé par la formation spontanée in-situ, décrite ci-dessus, des îlots ou motifs de GaN, le contrôle de leur géométrie et dispersion n'étant pas un pre-requis pour l'obtention de l'amélioration de la qualité des couches de GaN formées par ce procédé.

## Revendications

1. Procédé de réalisation d'une couche épitaxiale de nitrure de gallium (GaN) **caractérisé en ce qu'**il comprend le dépôt sur un substrat (1) d'une couche de diélectrique (3) fonctionnant comme un masque et la reprise du substrat masqué par du nitrure de gallium dopé avec un agent dopant permettant une augmentation relative de la vitesse de croissance selon les directions <10-11> par rapport à la vitesse de croissance selon la direction [0001], choisi dans le groupe constitué par le magnésium, le zinc, le cadmium, le béryllium, le calcium, le carbone, le silicium et le germanium, dans des conditions de dépôt par épitaxie en phase vapeur, de façon à induire le dépôt de motifs de nitrure de gallium et la croissance anisotrope et latérale desdits motifs (6), la croissance latérale étant poursuivie jusqu'à la coalescence des différents motifs, la couche de diélectrique (3) pouvant alternativement être une couche de diélectrique que l'on grave de façon à définir des ouvertures ou bien une monocouche atomique ou une couverture de l'ordre du plan atomique sur laquelle on dépose du nitrure de gallium suivi d'un recuit thermique induisant la formation d'îlots de nitrure de gallium quasi sans défauts.

2. Procédé de réalisation d'une couche épitaxiale de nitrure de gallium (GaN) selon la revendication 1,**caractérisé en ce que** le substrat est choisi dans le groupe constitué par le saphir, ZnO, 6H-SiC, LiAlO₂.

3. Procédé de réalisation d'une couche épitaxiale de nitrure de gallium (GaN) selon la revendication 1, **caractérisé en ce que** la couche de diélectrique est une couche de type SiₓN_{Y}.

4. Procédé de réalisation d'une couche épitaxiale de nitrure de gallium (GaN) selon l'une des revendications 1 à 3, **caractérisé en ce que** la couche de diélectrique est une monocouche atomique ou une couverture de l'ordre d'un plan atomique.

5. Procédé de réalisation d'une couche épitaxiale de nitrure de gallium (GaN) selon l'une des revendications 1 à 3, **caractérisé en ce que** l'on grave la couche de diélectrique de façon à définir des ouvertures et à exposer les zones du substrat en regard et l'on reprend le substrat masqué et gravé dans des conditions de dépôt, par épitaxie, de nitrure de gallium de façon à induire le dépôt de motifs de nitrure de gallium sur les zones en regard et la croissance anisotrope et latérale desdits motifs (6), la croissance latérale étant poursuivie jusqu'à la coalescence des différents motifs.

6. Procédé de réalisation d'une couche épitaxiale de nitrure de gallium (GaN) selon l'une des revendications 1 à 3, comprenant le dépôt sur un substrat (1) d'une couche mince de nitrure de gallium (2), **caractérisé en ce que** :
- l'on dépose sur ladite couche mince de nitrure de gallium une couche de diélectrique (3),
- on grave la couche de diélectrique de façon à définir des ouvertures (4) et à exposer les zones (5) de ladite couche mince de nitrure de gallium en regard,
- on reprend le substrat épitaxié masqué et gravé dans des conditions de dépôt, par épitaxie, de nitrure de gallium de façon à induire le dépôt de motifs de nitrure de gallium sur les zones en regard et la croissance anisotrope et latérale desdits motifs (6), la croissance latérale étant poursuivie jusqu'à la coalescence des différents motifs.

7. Procédé de réalisation d'une couche épitaxiale de nitrure de gallium (GaN) selon la revendication 5 ou 6, **caractérisé en ce que** les ouvertures sont des ouvertures ponctuelles ou sont sous forme de bandes.

8. Procédé de réalisation d'une couche épitaxiale de nitrure de gallium (GaN) selon la revendication 7, **caractérisé en ce que** les ouvertures ponctuelles sont des polygones réguliers, notamment de forme hexagonale.

9. Procédé de réalisation d'une couche épitaxiale de nitrure de gallium (GaN) selon les revendications 7 ou 8, **caractérisé en ce que** les ouvertures ponctuelles sont inscrites dans un cercle de rayon inférieur à 10µm.

10. Procédé de réalisation d'une couche épitaxiale de nitrure de gallium (GaN) selon la revendication 7, **caractérisé en ce que** les ouvertures sous forme de bandes ont une largeur inférieure à 10µm.

11. Procédé de réalisation d'une couche épitaxiale de nitrure de gallium (GaN) selon l'une des revendications 5 à 10, **caractérisé en ce que** la proportion de substrat ou de nitrure de gallium dégagée par rapport à la surface de totale du substrat est comprise entre 5 et 80%, avantageusement 5 et 50%.

12. Procédé de réalisation d'une couche épitaxiale de nitrure de gallium (GaN) selon l'une des revendications précédentes, **caractérisé en ce que** le substrat masqué, éventuellement épitaxié et gravé est repris par du nitrure de gallium non dopé.

13. Procédé de réalisation d'une couche épitaxiale de nitrure de gallium (GaN) selon l'une des revendications 1 à 11, **caractérisé en ce que** le substrat masqué, éventuellement épitaxié et gravé, est repris par du nitrure de gallium dopé avec un dopant choisi dans le groupe constitué par le magnésium, le zinc, le cadmium, le béryllium, le calcium, le carbone, le silicium, le germanium.

14. Procédé de réalisation d'une couche épitaxiale de nitrure de gallium (GaN) selon l'une des revendications précédentes, **caractérisé en ce que** les conditions de dépôt par épitaxie en phase vapeur impliquent l'utilisation d'un gaz vecteur de préférence constitué par un mélange N_{2:} H₂.

15. Procédé de réalisation d'une couche épitaxiale de nitrure de gallium (GAN) selon l'une des revendications 13 ou 14, **caractérisé en ce que** le substrat masque, éventuellement épitaxié et gravé, est repris
- par du nitrure de gallium non dopé, puis
- par du nitrure de gallium dopé.

16. Couche épitaxiale de nitrure de gallium dopé, **caractérisée en ce qu'**elle est susceptible d'être obtenue par le procédé selon l'une des revendications 1 à 15.

17. Couche épitaxiale de nitrure de gallium selon la revendication 16, **caractérisée en ce qu'**elle présente une épaisseur comprise entre 1µm et 1000 µm et **en ce qu'**elle est éventuellement séparée de son substrat.

18. Composant optoélectronique notamment diode laser, **caractérisé en ce qu'**ils sont munis d'une couche épitaxiale de nitrure de gallium selon l'une des revendications 16 ou 17.

19. Utilisation d'un agent dopant choisi dans le groupe constitué par le magnesium, le zinc, le cadmium, le béryllium, le calcium, le carbone, le silicium et le germanium permettant une augmentation relative de la vitesse de croissance des motifs de nitrure de gallium selon les directions <10-11> par rapport à la vitesse de croissance selon la direction [0001] lors de l'étape de reprise par épitaxie jusqu'à la coalescence des motifs de nitrure de gallium, dans des conditions de dépôt par épitaxie en phase vapeur,pour réalisation d'une couche épitaxiale de nitrure de gallium (GaN) comprenant préalablement à ladite reprise par épitaxie le dépôt sur le substrat d'une couche de diélectrique que l'on grave de façon à définir des ouvertures ou bien d'une monocouche atomique ou d'une couverture de l'ordre du plan atomique sur laquelle on dépose du nitrure de gallium suivi d'un recuit thermique induisant la formation d'îlots de nitrure de gallium quasi sans défauts.

## Patentansprüche

1. Verfahren zur Herstellung einer Galliumnitrid-Epitaxieschicht (GaN), **dadurch gekennzeichnet, dass** es das Auftragen einer als Maske wirkenden Dielektrikumschicht (3) auf ein Substrat (1) und das Aufwachsenlassen auf das maskierte Substrat von Galliumnitrid umfasst, welches mit einem Dotierungsmittel dotiert ist, welches eine relative Erhöhung der Wachstumsgeschwindigkeit gemäß den Richtungen <10-11> bezogen auf die Wachstumsgeschwindigkeit gemäß der Richtung [0001] erlaubt, welches aus der aus Magnesium, Zink, Cadmium, Beryllium, Calcium, Kohlenstoff, Silicium und Germanium bestehenden Gruppe ausgewählt wird, unter den Bedingungen einer epitaktischen Abscheidung aus der Gasphase derart, dass das Auftragen von Galliumnitrid-Strukturelementen und das anisotrope und seitliche Wachstum der Strukturelemente (6) bewirkt werden, wobei das seitliche Wachstum bis zum Verwachsen der verschiedenen Strukturelemente fortgeführt wird, und die Dielektrikumschicht (3) alternativ eine Dielektrikumschicht, welche man derart ätzt, dass Öffnungen definiert werden, oder ebenso eine atomare Einzelschicht oder eine Deckschicht in der Größenordnung einer atomaren Abmessung sein kann, auf die man Galliumnitrid aufträgt, gefolgt von einem thermischen Tempern, das die Bildung von praktisch fehlerfreien Galliumnitrid-Inseln bewirkt.

2. Verfahren zur Herstellung einer Galliumnitrid-Epitaxieschicht (GaN) nach Anspruch 1, **dadurch gekennzeichnet, dass** das Substrat aus der aus Saphir, ZnO, 6H-SiC, LiAlO₂ bestehenden Gruppe ausgewählt wird.

3. Verfahren zur Herstellung einer Galliumnitrid-Epitaxieschicht (GaN) nach Anspruch 1, **dadurch gekennzeichnet, dass** die Dielektrikumschicht eine Schicht vom Typ SiₓN_{y} ist.

4. Verfahren zur Herstellung einer Galliumnitrid-Epitaxieschicht (GaN) nach einem der Ansprüche 1 bis 3, **dadurch gekennzeichnet, dass** die Dielektrikumschicht eine atomare Einzelschicht oder eine Deckschicht in der Größenordnung einer atomaren Abmessung ist.

5. Verfahren zur Herstellung einer Galliumnitrid-Epitaxieschicht (GaN) nach einem der Ansprüche 1 bis 3, **dadurch gekennzeichnet, dass** man die Dielektriumschicht so ätzt, dass Öffnungen definiert werden und man die Zonen des gegenüberstehenden Substrats freilegt, und dass man auf das maskierte und geätzte Substrat unter den Bedingungen einer epitaktischen Abscheidung Galliumnitrid so aufwachsen lässt, dass das Auftragen von Galliumnitrid-Strukturelementen auf den gegenüberstehenden Zonen und das anisotrope und seitliche Wachstum der Strukturelemente (6) bewirkt werden, wobei das seitliche Wachstum bis zum Verwachsen der verschiedenen Strukturelemente fortgeführt wird.

6. Verfahren zur Herstellung einer Galliumnitrid-Epitaxieschicht (GaN) nach einem der Ansprüche 1 bis 3, welches das Auftragen einer dünnen Galliumnitrid-Schicht (2) auf einem Substrat (1) umfasst, **dadurch gekennzeichnet, dass**:
- man auf die dünne Galliumnitrid-Schicht eine Dielektrikumschicht (3) aufträgt,
- man die Dielektrikumschicht so ätzt, dass Öffnungen (4) definiert werden und die Zonen (5) der gegenüberstehenden dünnen Galliumnitrid-Schicht freigelegt werden,
- man auf das epitaktisch aufgewachsene, maskierte und geätzte Substrat unter den Bedingungen eines epitaktischen Auftragens Galliumnitrid so aufwachsen lässt, dass das Auftragen von Galliumnitrid-Strukturelementen auf den gegenüberstehenden Zonen und das anisotrope und seitliche Wachstum der Strukturelemente (6) bewirkt werden, wobei das seitliche Wachstum bis zum Verwachsen der verschiedenen Strukturelemente fortgeführt wird.

7. Verfahren zur Herstellung einer Galliumnitrid-Epitaxieschicht (GaN) nach Anspruch 5 oder 6, **dadurch gekennzeichnet, dass** die Öffnungen punktförmige oder streifenförmige Öffnungen sind.

8. Verfahren zur Herstellung einer Galliumnitrid-Epitaxieschicht (GaN) nach Anspruch 7, **dadurch gekennzeichnet, dass** die punktförmigen Öffnungen regelmäßige Polygone, insbesondere von hexagonaler Form sind.

9. Verfahren zur Herstellung einer Galliumnitrid-Epitaxieschicht (GaN) nach den Ansprüchen 7 oder 8, **dadurch gekennzeichnet, dass** die punktförmigen Öffnungen eingeschrieben sind in einen Kreis mit einem Radius unter 10 µm.

10. Verfahren zur Herstellung einer Galliumnitrid-Epitaxieschicht (GaN) nach Anspruch 7, **dadurch gekennzeichnet, dass** die streifenförmigen Öffnungen eine Breite unter 10 µm aufweisen.

11. Verfahren zur Herstellung einer Galliumnitrid-Epitaxieschicht (GaN) nach einem der Ansprüche 5 bis 10, **dadurch gekennzeichnet, dass** der Anteil des Substrats oder von Galliumnitrid, welcher bezogen auf die gesamte Oberfläche des Substrats freigesetzt wird, zwischen 5 und 80%, vorteilhafterweise 5 und 50% eingeschlossen liegt.

12. Verfahren zur Herstellung einer Galliumnitrid-Epitaxieschicht (GaN) nach einem der Ansprüche 1 bis 11, **dadurch gekennzeichnet, dass** man auf das maskierte, gegebenenfalls epitaktisch aufgewachsene und geätzte Substrat mit Magnesium dotiertes Galliumnitrid aufwachsen lässt.

13. Verfahren zur Herstellung einer Galliumnitrid-Epitaxieschicht (GaN) nach Anspruch 12, **dadurch gekennzeichnet, dass** das Verhältnis Dotierungsmittel/Ga in Mol in der Gasphase über 0 und unter oder gleich 1 beträgt.

14. Verfahren zur Herstellung einer Galliumnitrid-Epitaxieschicht (GaN) nach einem der vorstehenden Ansprüche, **dadurch gekennzeichnet, dass** die Bedingungen eines epitaktischen Abscheidens aus der Gasphase die Verwendung eines Trägergases, welches vorzugsweise aus einer N₂:H₂-Mischung besteht, implizieren.

15. Verfahren zur Herstellung einer Galliumnitrid-Epitaxieschicht (GaN) nach einem der Ansprüche 13 oder 14, **dadurch gekennzeichnet, dass** man auf das maskierte, gegebenenfalls epitaktisch aufgewachsene und geätzte Substrat aufwachsen lässt:
- nicht-dotiertes Galliumnitrid, dann
- dotiertes Galliumnitrid.

16. Dotierte Galliumnitrid-Epitaxieschicht, **dadurch gekennzeichnet, dass** sie durch das Verfahren nach einem der Ansprüche 1 bis 15 erhalten werden kann.

17. Galliumnitrid-Epitaxieschicht nach Anspruch 16, **dadurch gekennzeichnet, dass** sie eine Dicke zwischen 1 µm und 1000 µm aufweist und dass sie gegebenenfalls von ihrem Substrat getrennt ist.

18. Optoelektronisches Bauelement, insbesondere Laserdiode, **dadurch gekennzeichnet, dass** sie mit einer Galliumnitrid-Epitaxieschicht nach einem der Ansprüche 16 oder 17 ausgestattet sind.

19. Verwendung eines Dotierungsmittels, ausgewählt aus der Gruppe bestehend aus Magnesium, Zink, Cadmium, Beryllium, Calcium, Kohlenstoff, Silicium und Germanium, welches eine relative Erhöhung der Wachstumsgeschwindigkeit von Galliumnitrid-Strukturelementen gemäß den Richtungen <10-11> bezogen auf die Wachstumsgeschwindigkeit gemäß der Richtung [0001] erlaubt während des Schritts des epitaktischen Aufwachsenlassens bis zum Verwachsen der Galliumnitrid-Strukturelemente unter den Bedingungen eines epitaktischen Abscheidens aus der Dampfphase, für die Herstellung einer Galliumnitrid-Epitaxieschicht (GaN), welche vor dem epitaktischen Aufwachsenlassen das Auftragen auf dem Substrat einer Dielektrikumschicht, die man derart ätzt, dass Öffnungen definiert werden, oder ebenso einer atomaren Einzelschicht oder einer Deckschicht in der Größenordnung einer atomaren Abmessung umfasst, auf die man Galliumnitrid aufträgt, gefolgt von einem thermischen Tempern, das die Bildung von praktisch fehlerfreien Galliumnitrid-Inseln bewirkt.

## Claims

1. Process for producing an epitaxial layer of gallium nitride (GaN), **characterized in that** it comprises the deposition on a substrate (1) of a dielectric layer (3) functioning as a mask and the regrowth of gallium nitride on the masked substrate under vapour phase epitaxial deposition conditions, said gallium nitride being doped with a doping agent allowing a relative increase in the growth rate in the <1011> directions compared with the growth rate in the [0001] direction, the said doping agent being chosen from the group consisting of magnesium, zinc, cadmium, beryllium, calcium, carbon, silicon and germanium, so as to induce the deposition of gallium nitride features and the anisotropic and lateral growth of said features (6), the lateral growth being continued until coalescence of the various features, it being possible for the dielectric layer (3) to be, alternatively, a dielectric layer that is etched so as to define apertures or else an atomic monolayer or a cover of the order of an atomic plane, on which gallium nitride is deposited, followed by thermal annealing that induces the formation of almost defect-free gallium nitride islands.

2. Process for producing an epitaxial layer of gallium nitride (GaN) according to Claim 1, **characterized in that** the substrate is chosen from the group consisting of sapphire, ZnO, 6H-SiC and LiAlO₂.

3. Process for producing an epitaxial layer of gallium nitride (GaN) according to Claim 1, **characterized in that** the dielectric layer is a layer of the SiₓN_{y} type.

4. Process for producing an epitaxial layer of gallium nitride (GaN) according to one of Claims 1 to 3, **characterized in that** the dielectric layer is an atomic monolayer or a cover of the order of one atomic plane.

5. Process for producing an epitaxial layer of gallium nitride (GaN) according to one of Claims 1 to 3, **characterized in that** the dielectric layer is etched so as to define apertures and to expose the facing regions of the substrate, and gallium nitride is regrown under epitaxial deposition conditions on the masked and etched substrate so as to induce the deposition of gallium nitride features on the facing regions and the anisotropic and lateral growth of said features (6), the lateral growth being continued until coalescence of the various features.

6. Process for producing an epitaxial layer of gallium nitride (GaN) according to one of Claims 1 to 3, comprising the deposition of a thin gallium nitride layer (2) on a substrate (1), **characterized in that**:
- a dielectric layer (3) is deposited on said thin gallium nitride layer;
- the dielectric layer is etched so as to define apertures (4) and to expose those regions (5) of said thin gallium nitride layer which face them;
- gallium nitride is regrown under epitaxial deposition conditions on the epitaxially grown, masked and etched substrate so as to induce the deposition of gallium nitride features on the facing regions and the anisotropic and lateral growth of said regions (6), the lateral growth being continued until coalescence of the various features.

7. Process for producing an epitaxial layer of gallium nitride (GaN) according to Claim 5 or 6, **characterized in that** the apertures are discrete apertures or are apertures in the form of stripes.

8. Process for producing an epitaxial layer of gallium nitride (GaN) according to Claim 7, **characterized in that** the discrete apertures are regular polygons, especially ones of hexagonal shape.

9. Process for producing an epitaxial layer of gallium nitride (GaN) according to Claim 7 or 8, **characterized in that** the discrete apertures are inscribed in a circle of radius of less than 10 µm.

10. Process for producing an epitaxial layer of gallium nitride (GaN) according to Claim 7, **characterized in that** the apertures in the form of stripes have a width of less than 10 µm.

11. Process for producing an epitaxial layer of gallium nitride (GaN) according to one of Claims 5 to 10, **characterized in that** the exposed surface proportion of substrate' or of gallium nitride with respect to the total area of the substrate is between 5 and 80%, advantageously 5 and 50%.

12. Process for producing an epitaxial layer of gallium nitride (GaN) according to one of Claims 1 to 11, **characterized in that** magnesium-doped gallium nitride is regrown on the masked, optionally epitaxially grown, and etched substrate.

13. Process for producing an epitaxial layer of gallium nitride (GaN) according to Claim 12, **characterized in that** the dopant/Ga molar ratio in the vapour phase is greater than 0 and less than or equal to 1.

14. Process for producing an epitaxial layer of gallium nitride (GaN) according to one of the preceding Claims, **characterized in that** the vapour phase epitaxial deposition conditions involve the use of a carrier gas preferably consisting of an N₂/H₂ mixture.

15. Process for producing an epitaxial layer of gallium nitride (GaN) according to either of Claims 13 and 14, **characterized in that** the masked, optionally epitaxially grown and etched substrate undergoes regrowth
- with undoped gallium nitride, then
- with doped gallium nitride.

16. Epitaxial doped gallium nitride layer, **characterized in that** it can be obtained by the process according to one of Claims 1 to 15.

17. Epitaxial gallium nitride layer according to Claim 16, **characterized in that** it has a thickness of between 1 µm and 1000 µm and **in that** it is optionally separated from its substrate.

18. Optoelectronic component, especially a diode laser, **characterized in that** it is provided with an epitaxial layer of gallium nitride according to either of Claims 16 and 17.

19. Use of a doping agent chosen from the group consisting of magnesium, zinc, cadmium, beryllium, calcium, carbon, silicon and germanium, allowing a relative increase in the rate of growth of gallium nitride features in the <1011> directions compared with the growth rate in the [0001] direction during the expitaxial regrowth step until coalescence of the gallium nitride features, under vapour phase expitaxial deposition conditions for producing an epitaxial layer of gallium nitride (GaN) comprising, prior to the said epitaxial regrowth, the deposition on the substrate of a dielectric layer that is etched so as to define apertures or else an atomic monolayer or a cover of the order of an atomic plane, on which gallium nitride is deposited, followed by thermal annealing that induces the formation of almost defect-free gallium nitride islands.
